# EUROPÄISCHE PATENTSCHRIFT

(11) **EP 2 592 913 B1**
(45) Veröffentlichungstag und Bekanntmachung des Hinweises auf die Patenterteilung: **06.01.2021**
(21) Anmeldenummer: 12191451.9
(22) Anmeldetag: 06.11.2012
(51) Int. Cl.: H05K 1/18, H05K 1/02, H02J 7/00

(54) **Unmittelbare Kontaktierung eines Energiespeichers oder einer Last mittels eines elektronischen Lastschalters**
Direct contacting of an energy storage device or a load with an electronic load switch
Mise en contact directe d'un accumulateur d'énergie ou d'une charge au moyen d'un commutateur de charge électronique

(30) Priorität: 10.11.2011 DE 102011055223
(43) Veröffentlichungstag der Anmeldung: 15.05.2013
(73) Patentinhaber: Fraunhofer-Gesellschaft zur Förderung der angewandten Forschung e.V., 80686 München (DE)
(72) Erfinder: Kähler, Dirk, Dr., 25524 Itzehoe (DE); Puls, Sebastian, 25524 Itzhoe (DE); Poech, Max-Hermann, 25560 Schenefeld (DE)
(74) Vertreter: Strehl Schübel-Hopf & Partner

(56) Entgegenhaltungen:
- WO-A1-89/05066
- DE-A1- 2 557 379
- DE-A1- 3 423 924
- DE-A1- 10 303 294
- JP-A- 2005 310 425
- US-A1- 2007 138 651
- US-A1- 2010 129 687
- Michael Schüler ET AL: "Der 1,3 GHz-Topfkreisoszillator", http://www.emsp.tu-berlin.de/menue/studium _und_lehre/mixed-signal-baugruppen/das_pro jekt_high_speed_2/, 29. September 2006 (2006-09-29), Seiten 1-38, XP055054700, Berlin, Germany Gefunden im Internet: URL:http://www.emsp.tu-berlin.de/fileadmin /fg232/Lehre/MixedSignal/Dateien/High_Spee d_2/07_Oszillator_1300MHz.pdf [gefunden am 2013-02-27]
- International Rectifier: "IRF9383MPbF", , 19. Oktober 2011 (2011-10-19), Seiten 1-9, XP055054709, Gefunden im Internet: URL:http://www.irf.com/product-info/datash eets/data/irf9383mpbf.pdf [gefunden am 2013-02-27]

## Beschreibung

Die Erfindung betrifft eine elektrische Schaltung, wie z. B. eine Elektronikplatine, eine Flachbaugruppe oder eine gedruckte Leiterplatte (printed circuit board, PCB), die elektrische Kontakte zum Anschließen eines Energiespeichers, wie z. B. einer Batterie oder eines Akkumulators (Akkus), oder zum Anschließen einer Last, wie z.B. einer Glühbirne, aufweist. Die Erfindung betrifft ferner ein System aus einer derartigen elektrischen Schaltung und einem Energiespeicher bzw. einer Last sowie ein Verfahren zum elektrischen Kontaktieren des Energiespeichers bzw. der Last an der elektrischen Schaltung in einem solchen System.

Elektrische und elektronische Geräte, die mit Batterien oder Akkus betrieben werden, verwenden in vielen Fällen mechanisch angepresste Kontakte zum elektrischen Anschluss des Energiespeichers, wie z.B. in DE 199 47 059 A1 gezeigt. Derartige Kontakte sind zwar in der Regel nicht teuer, erfordern jedoch einigen Montageaufwand an der zugrunde liegenden Schaltung, der häufig manuell erfolgen muss.

Traditionell werden Batterien oder Akkus mit Federkontakten elektrisch kontaktiert und mechanisch fixiert. Die Federkontakte werden wiederum mit Kabeln an die elektrische Schaltung, z. B. an eine Elektronikplatine, angeschlossen.

Erfordert ein Akku beispielsweise eine Temperaturüberwachung, so wird ein zusätzlicher Temperatursensor am Akku befestigt und ebenfalls über Kabel mit der Elektronik verbunden.

Ähnliches wird in der Praxis häufig auch zur Kontaktierung bzw. Temperaturüberwachung einer Last, wie z.B. eines ohmschen Lastwiderstands, eines elektrischen Geräts oder einer Elektronikbaugruppe eingesetzt.

Der Erfindung liegt die Aufgabe zugrunde, mindestens einen Federkontakt zum elektrischen Anschließen eines Energiespeichers an eine elektrische Schaltung zu eliminieren und dadurch den Montageaufwand zu reduzieren. Darüber hinaus ist es Aufgabe der Erfindung, die Montage eines zusätzlichen Temperaturfühlers zur Überwachung der Temperatur des Energiespeichers ebenfalls überflüssig zu machen. Die Aufgabe der Erfindung umfasst auch die Verwendung einer (elektronischen) Last anstelle eines Energiespeichers.

Diese Aufgabe wird erfindungsgemäß durch das im Anspruch 1 definierte System und das zugehörige Verfahren gemäß Anspruch 6 gelöst. Das erfindungsgemäße System umfasst eine elektrische Schaltung, die elektrische Kontakte zum Anschließen eines Energiespeichers und/oder einer Last aufweist, wobei mindestens einer der elektrischen Kontakte als ein elektronischer Lastschalter zum unmittelbaren Kontaktieren eines ersten elektrischen Anschlusses des Energiespeichers bzw. der Last ausgebildet ist. Der elektronische Lastschalter wird im Folgenden der Einfachheit halber auch kurz als Lastschalter bezeichnet.

Insbesondere kann also die elektrische Schaltung nach der Erfindung elektrische Kontakte zum Anschließen eines Energiespeichers aufweisen, wobei mindestens einer der elektrischen Kontakte als ein elektronischer Lastschalter zum unmittelbaren Kontaktieren eines ersten elektrischen Anschlusses des Energiespeichers ausgebildet ist.

Der Lösungsansatz gemäß der Erfindung besteht darin, an Stelle eines Federkontakts einen elektronischen Lastschalter bzw. gegebenenfalls zusätzlich dessen Gehäuse zum Herstellen eines mechanischen und elektrischen Kontakts zwischen der elektrischen Schaltung und einem elektrischen Anschluss des Energiespeichers zu nutzen.

Da der Lastschalter wie ein normales Bauteil auf einer Platine angebracht/bestückt werden kann, entfällt in der erfindungsgemäßen Schaltung mindestens ein Federkontakt samt Kabel zum Kontaktieren des Energiespeichers. Die Kontaktierung von beispielsweise Batterien und Akkus wird dadurch insgesamt vereinfacht, indem der Montageaufwand mindestens eines elektrischen Kontakts in der Schaltung verringert wird. Die Erfindung hat darüber hinaus den Vorteil, die Kosten für den Federkontakt samt Kabel einzusparen.

Für die beschriebene Kontaktierungsform ist das Funktionsprinzip des Lastschalters unerheblich. Wesentlich ist lediglich, dass ein für einen mechanischen und elektrischen Kontakt zum Energiespeicher oder zur Last geeigneter Bereich des Lastschalters, z.B. einer seiner Anschlüsse oder ein Gehäuse, vorgesehen ist, der elektrisch leitend mit dem Lastschalter verbunden ist. Es ist jedoch auch möglich, Lastschalter, z.B. elektronische Leistungsschalter (MOSFets etc.), ohne Gehäuse in einem Aufbau nach der Erfindung einzusetzen. In größerer Stückzahl können diese Bauelemente direkt vom Halbleiterhersteller bezogen werden.

Sofern in der elektrischen Schaltung ein (weiterer) elektronischer Lastschalter nicht ohnehin schon vorhanden ist, bietet der erfindungsgemäß vorgesehene Lastschalter ferner die Möglichkeit, einen mechanischen Schalter dadurch zu ersetzen. Insbesondere ermöglicht der erfindungsgemäß eingesetzte Lastschalter eine Notabschaltung, z.B. bei Überlast, oder einen zeitgesteuerten Betrieb. Dies kann sowohl zum Ein- und Ausschalten eines Energiespeichers in der Schaltung als auch für einen mit dem Energiespeicher verbundenen Teil der Schaltung realisiert sein.

Für elektrische Schaltungen mit einem Energiespeicher und mit einem auf eine herkömmliche Weise zusätzlich vorgesehenen Schalter sei hingegen beispielhaft auf EP 1 952 439 B1, DE 10 2010 053 942 A1 oder JP 2005310425 A verwiesen. Weitere Beispiele sind in US 2007/138651 A1, WO 89/005066 A1, DE 34 239 24 A1, DE 25 57 379 A1, DE 103 03 294 A1, US 2010/129687 A1, sowie in "Der 1,3 GHz-Topfkreisoszillator", Michael Schüler et al., URL: http://www.emsp.tu-berlin.de/fileadmin/fg232/Lehre/MixedSignal/Dateien/High_Speed_2/07_Oszillator_1300MHz.pdf, und International Rectifier, "IRF9383MPbF", URL: http://www.irf.com/product-info/datasheets/data/irf9383mpbf.pdf offenbart.

Ein weiterer Vorteil des erfindungsgemäßen Prinzips besteht darin, dass elektronische Leistungsschalter in der Regel eine temperaturabhängige Kennlinie aufweisen, so dass sie, sofern sie einen guten thermischen Kontakt zum daran angeschlossenen Energiespeicher aufweisen, für die Messung von dessen Temperatur genutzt werden können. Das Letztere ist in der Regel der Fall. Dadurch entfällt insbesondere die Montage eines zusätzlichen Temperaturfühlers zur Überwachung der Betriebstemperatur eines Energiespeichers und der damit verbundene Kosten- und Platzaufwand.

In spezifischen Ausgestaltungen können elektronische Leistungsschalter, die auf das Schalten großer Leistungen (wie z.B. von einigen Watt oder Kilowatt) ausgelegt sind, als Lastschalter eingesetzt werden. Beispielsweise können folgende Bauelemente eingesetzt werden: Feldeffekt-Transistoren, z.B. MOSFets, Bipolar-Transistoren, IGBTs (Insulated Gate Bipolar Transistor), Thyristoren, Triacs. In erster Linie sind hier die Feldeffekttransistoren geeignet.

Die Erfindung kann bei allen batterie- oder akkubetriebenen Geräten eingesetzt werden. Insbesondere ist sie bei Geräten von Vorteil, bei denen der Energiespeicher selten ausgewechselt wird.

Alles oben in Bezug auf einen Energiespeicher Gesagte gilt analog auch für die Kontaktierung einer Last alternativ zu einem Energiespeicher. Eine Kombination aus einem (oder mehreren) nach der Erfindung kontaktierbaren/kontaktierten Energiespeichern sowie einer (oder mehreren) nach der Erfindung kontaktierbaren/kontaktierten Lasten in einer und derselben Schaltung ist ebenfalls möglich.

Als Beispiel für eine Last sind insbesondere Leuchtmittel (z.B. Glühbirnen oder Halogenlampen) zu nennen, für welche ein Kontakt in der zugrunde liegenden elektrischen Schaltung als Last- bzw. Leistungsschalter ausgeführt ist. Da die Anwendung sich dann nicht auf Gleichspannung beschränkt, können als Leistungsschalter auch Thyristoren oder Triacs zum Einsatz kommen.

Bei der Kontaktierung einer Last ist z.B. bei den für Glühbirnen typischen Anordnungen ein mittlerer Kontakt (Mittenkontakt) in einer Schraubfassung für den Einsatz eines Lastschalters als eines unmittelbaren Kontakts geeignet. Möglich sind aber auch andere Anordnungen der elektrischen Kontakte, z.B. der Federkontakte, wie bei Halogenbirnen mit Anschluss GU10, oder auch beliebige andere Steckkontakte, wobei jeweils zumindest einer der elektrischen Kontakte erfindungsgemäß durch einen Last- bzw. Leistungsschalter ersetzt ist.

Bevorzugte Ausführungsformen der Erfindung sind in den abhängigen Ansprüchen und der nachfolgenden Beschreibung angegeben. Die darin enthaltenen Merkmale können auch für das erfindungsgemäße Verfahren zum elektrischen Kontaktieren eines Energiespeichers bzw. einer Last an einer elektrischen Schaltung eingesetzt werden, ohne dass explizit darauf hingewiesen wird. Vorzugsweise richtet sich die Erfindung in allen Anspruchskategorien auf die unmittelbare Kontaktierung eines Energiespeichers mittels eines elektronischen Lastschalters. Eine erfindungsgemäße Kontaktierung einer Last ist jedoch eine wichtige Alternative. Das im Folgenden in Bezug auf einen Energiespeicher Gesagte kann daher analog auch bei der Kontaktierung einer Last verwendet werden.

Weist die elektrische Schaltung eine (Elektronik-)Platine auf, die derart ausgebildet ist, dass sie ein zumindest einmaliges Biegen erlaubt (z.B. in den dazu vorgesehenen Bereichen mit reduzierter Dicke), so steht einer direkten Kontaktierung eines Energiespeichers mittels eines Lastschalters auch geometrisch nichts im Wege. D.h. die Platine kann passend zu der räumlichen Anordnung der elektrischen Anschlüsse des Energiespeichers zurechtgebogen werden. Ein Beispiel dafür ist eine semiflexible Flachbaugruppe oder gedruckte Leiterplatte (semi-flex circuit board bzw. semi-flex PCB). Alternativ dazu können auch mehrfach biegbare Platinen (z.B. multi-flex circuit boards bzw. multi-flex PCBs) verwendet werden.

Zur mechanischen Stabilisierung bzw. zum mechanischen Andrücken der elektrischen Kontakte der erfindungsgemäßen Schaltung an die elektrischen Anschlüsse eines Energiespeichers kann ein Federelement, z.B. eine Schrauben- oder Biegefeder, eingesetzt werden. Das Federelement braucht keinen hohen Anforderungen an elektrisch leitende Bauelemente zu entsprechen und kann beliebig einfach und robust ausgebildet sein. Es kann z.B. in ein um die Schaltung herum angeordnetes (Spritzguss-)Gehäuse integriert werden/sein, so dass auf ein separates, elektrisch zu kontaktierendes Federelement verzichtet werden kann.

Der Lastschalter im Sinne der Erfindung kann in allen Fällen beispielsweise als Transistor, insbesondere als Feldeffekttransistor, ausgeführt sein. In diesem Fall lässt er sich besonders gut zusätzlich dazu nutzen, die Temperatur eines Energiespeichers zu messen, welcher nach der erfindungsgemäßen elektrischen Kontaktierung im thermischen Gleichgewicht mit dem Lastschalter steht. Alternativ können als Lastschalter auch andere elektronische Schalter, wie z.B. Thyristoren, insbesondere Gate Turn-Off Thyristoren (GTO-Thyristoren), eingesetzt werden.

Vorzugsweise weist der Lastschalter in allen Fällen ein Gehäuse auf, das elektrisch leitend mit dem Lastschalter verbunden ist und einen zur Kontaktierung eines Energiespeichers geometrisch geeigneten Bereich aufweist. Beispielsweise hat das Gehäuse eine flach ausgebildete metallische Oberseite, die als Kontaktstelle für den Energiespeicher dienen kann. Besonders gut geeignet sind in diesem Sinne Feldeffekttransistoren (FET). Solche Leistungsschalter sind bekannt, verwiesen sei z.B. auf Feldeffekttransistoren der Fa. International Rectifier, die unter der Marke DirectFET™ vertrieben werden. Wie bereits erwähnt, ist es im Rahmen der Erfindung ebenfalls durchaus möglich, Lastschalter, wie z.B. Elektronische Leistungsschalter (MOSFets etc.), ohne Gehäuse einzusetzen.

Es sind auch Ausgestaltungen der erfindungsgemäßen Schaltung mit zwei Lastschaltern als den elektrischen Kontakten zum Kontaktieren beider elektrischer Anschlüsse eines Energiespeichers möglich. Alternativ kann für den zweiten Anschluss des Energiespeichers in der Schaltung ein metallischer Kontakt, wie z.B. ein Teil der Platinenoberfläche oder ein Federkontakt vorgesehen sein. Weitere Varianten hierzu werden weiter unten angegeben. Wird die Platine geknickt, genügt eine metallische Fläche, wie z.B. eine Leiterbahn, zum Ankontaktieren des zweiten elektrischen Anschlusses. Die Federwirkung kann durch die Halterung der Platine, wozu sich z.B. ein äußeres Gehäuse eignen kann, erzielt werden.

Ein weiterer Aspekt der Erfindung ist ein System aus einer erfindungsgemäßen elektrischen Schaltung und einem daran elektrisch angeschlossenen Energiespeicher, dessen erster elektrischer Anschluss in einem direkten elektrischen und mechanischen Kontakt mit dem Lastschalter ist. Es können auch mehrere Energiespeicher in dem erfindungsgemäßen System vorgesehen sein, die ggf. jeweils mittels eines oder zwei Lastschalter(n) an der elektrischen Schaltung kontaktiert sind.

Der Energiespeicher kann eine Batterie, vorzugsweise eine wieder aufladbare Batterie, oder ein Akkumulator sein. Wie weiter oben bereits erwähnt, ist alternativ oder zusätzlich eine erfindungsgemäße Kontaktierung einer Last anstelle bzw. zusätzlich zum Energiespeicher in dem System möglich. Bei dieser Last kann es sich z.B. um ein Leuchtmittel, insbesondere eine Halogenlampe oder eine Glühbirne handeln.

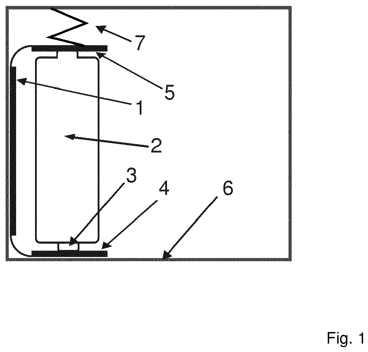

In einer bevorzugten Ausführungsform des erfindungsgemäßen Systems ist ein elastisches Element (Federelement), z.B. eine Feder, insbesondere eine Schrauben- oder Kegeldruckfeder aus Metall vorgesehen, das derart angeordnet ist, dass aufgrund seiner Rückstellkraft ein zweiter elektrischer Anschluss eines Energiespeichers mit Druck an dem zugehörigen zweiten elektrischen Kontakt, z.B. einer metallischen Leiterbahn, Punktstelle oder Erhebung der elektrischen Schaltung, anliegt. Das elastische Element sorgt dabei beispielsweise lediglich für einen mechanischen Druck und kann auch rückseitig an der elektrischen Schaltung angeordnet sein, beispielsweise wie bei einer in Fig. 1 gezeigten Anordnung. In diesem Fall kann es auch schlecht bis gar nicht elektrisch leitende Materialien, wie z.B. Kunststoff oder Gummi, enthalten oder daraus bestehen.

Ist der zweite elektrische Anschluss des Energiespeichers an einer von dem ersten elektrischen Anschluss abgewandten, gegenüberliegenden Seite des Energiespeichers angeordnet, so liegt durch das elastische Element auch der erste elektrische Anschluss mit Druck an dem als Lastschalter ausgebildeten ersten elektrischen Kontakt an. Dasselbe gilt auch bei den oben genannten Varianten mit einem Federkontakt als dem zweiten elektrischen Kontakt bzw. mit einer in einem Gehäuse federnd zurechtgebogenen Platine, insbesondere auch in Abwesenheit des zusätzlichen elastischen Elements im hier beschriebenen Sinne.

Alternativ dazu kann in einem erfindungsgemäßen System mit einem Energiespeicher, dessen beide elektrische Anschlüsse nebeneinander an einer Vorderseite des Energiespeichers liegen, ein elastisches Element vorgesehen sein, das an einer Rückseite des kontaktierten Energiespeichers mit Druck anliegt. Dadurch wird nämlich wiederum erreicht, dass auch die beiden elektrischen Anschlüsse des Energiespeichers mit Druck an den zugehörigen elektrischen Kontakten der erfindungsgemäßen Schaltung anliegen.

Vorzugsweise ist in dem erfindungsgemäßen System ein bereits weiter oben erwähntes Außengehäuse um die elektrische Schaltung und einen daran angeschlossenen Energiespeicher vorgesehen, wobei die Schaltung mit ihrer Rückseite dem Außengehäuse zugewandt sein und das Außengehäuse insbesondere eine mechanisch stabilisierende und schützende Funktion für die Schaltung, die z.B. eine flexible Elektronikplatine enthält, erfüllen kann.

In einem solchen System kann das elastische Element in der oben beschriebenen bevorzugten Ausführungsform zwischen der (Rückseite der) Schaltung und dem Außengehäuse angeordnet, insbesondere befestigt, sein und zwar derart, dass der zweite elektrische Kontakt der Schaltung mit Druck an dem zweiten Anschluss des Energiespeichers anliegt.

In einem weiteren Aspekt betrifft die Erfindung ein Verfahren zum elektrischen Kontaktieren eines Energiespeichers an einer elektrischen Schaltung, insbesondere an der Schaltung einer der weiter oben spezifizierten Arten, bei dem ein elektrischer Anschluss des Energiespeichers in einen unmittelbaren mechanischen und elektrischen Kontakt mit einem in der elektrischen Schaltung enthaltenen elektronischen Lastschalter gebracht und dadurch an der Schaltung kontaktiert wird.

Alternativ oder zusätzlich zum elektrischen Kontaktieren eines Energiespeichers kann das erfindungsgemäße Verfahren auch zum elektrischen Kontaktieren einer Last an einer elektrischen Schaltung dienen.

In einem ersten Verfahrensschritt kann ggf. eine zumindest einmal biegbare Elektronikplatine zumindest lokal zu einer U-Form verbogen werden, wobei an einem der dadurch gebildeten Schenkel innenseitig ein elektronischer Lastschalter im Sinne der Erfindung zum Kontaktieren eines Anschlusses des Energiespeichers angeordnet ist. In einem weiteren Schritt wird dann der Energiespeicher in die U-Form derart hineingesetzt, dass sein erster elektrischer Anschluss dadurch in einen unmittelbaren mechanischen und elektrischen Kontakt mit dem Lastschalter gelangt.

Ein zweiter Anschluss des Energiespeichers kann dabei z.B. mittels eines als Federkontakt ausgebildeten zweiten elektrischen Kontakts der Schaltung angeschlossen werden oder mittels eines, z.B. rein mechanischen, elastischen Elements an den zweiten elektrischen Kontakt der Schaltung angedrückt werden. Dies kann ggf. in Anordnungen nach den obigen Beispielen für das erfindungsgemäße System realisiert werden.

Die verschiedenen Ausführungsformen der Erfindung lassen sich auch untereinander kombinieren.

Weitere Vorteile der Erfindung werden nachfolgend anhand des in der Zeichnung und der zugehörigen Beschreibung dargestellten Ausführungsbeispiels erläutert. Dies soll keine beschränkende Wirkung für den Erfindungsgegenstand haben.

Es zeigt:
- Fig. 1: ein Ausführungsbeispiel des erfindungsgemäßen Systems mit einem Energiespeicher

Fig. 1 zeigt schematisch ein erfindungsgemäßes System, das eine semiflexible gedruckte Leiterplatte (semi-flex PCB) bzw. eine semiflexible Flachbaugruppe 1 als elektrische Schaltung, eine Batterie (battery) 2 als Energiespeicher und einen Feldeffekttransistor DirectFET™ 3 als elektrischen Lastschalter aufweist.

Die semi-flex PCB 1 ist durch das Verbiegen an zwei Stellen mit reduzierter Dicke zu einer U-Form geformt worden, deren Abmessungen zu denen der Batterie 2 passen. Die Innenseite eines ersten Schenkels 4 der U-Form ist mit dem DirectFET™ 3 zum Kontaktieren eines ersten Anschlusses des Energiespeichers 2 bestückt. Die Innenseite eines gegenüberliegenden zweiten Schenkels 5 weist eine elektrische Kontaktstelle zum Kontaktieren eines zweiten Anschlusses des Energiespeichers 2 auf (nicht gezeigt).

Das System ist in einem Außengehäuse (z.B. einem "injection molded enclosure") 6 untergebracht, welches hier beispielsweise durch Spritzgießen hergestellt ist. Eine zwischen den beiden Schenkeln 4, 5 angeordnete Basis und der erste Schenkel 4 der U-förmigen Schaltung 1 liegen mit deren Rückseiten am Außengehäuse 6 an. Das Außengehäuse 6 erfüllt hier sowohl eine stützende bzw. tragende Funktion für die Schaltung 1 als auch eine gegen etwaige äußere Störungen schützende Funktion für das erfindungsgemäße System.

Zwischen der Außenseite des zweiten Schenkels 5 der U-Form und dem Außengehäuse 6 ist eine Feder (elastic element of the enclosure) 7 angeordnet. Diese sorgt dafür, dass die elektrischen Anschlüsse der Batterie 2 mit einem gewissen Druck an dem Lastschalter 3 bzw. an der gegenüberliegenden Kontaktstelle der elektrischen Schaltung 1 anliegen. Die Feder 7 kann auch Bestandteil des Spritzgussgehäuses 6 sein.

## Patentansprüche

1. System, umfassend eine elektrische Schaltung (1), die einen ersten und einen zweiten elektrischen Kontakt zum Anschließen an einen ersten und einen zweiten elektrischen Anschluss eines Energiespeichers (2) und/oder einer Last aufweist, und ein um die elektrische Schaltung (1) angeordnetes Außengehäuse (6), wobei
mindestens einer der genannten elektrischen Kontakte ein elektronischer Lastschalter (3) ist, der ein leitendes Gehäuse aufweist, das so ausgestaltet ist, dass es beim Anschließen des Energiespeichers (2) bzw. der Last einen unmittelbaren elektrischen und mechanischen Kontakt zu dem ersten elektrischen Anschluss des Energiespeichers (2) bzw. der Last herstellt,
entweder der zweite elektrische Kontakt der elektrischen Schaltung (1) an dem der zweite elektrische Anschluss des Energiespeichers (2) bzw. der Last anzuschließen ist, ein metallischer Federkontakt ist, oder das System ein elastisches Element (7), insbesondere eine Feder, aufweist, mittels dessen der zweite elektrische Anschluss des Energiespeichers (2) bzw. der Last an dem zweiten elektrischen Kontakt der elektrischen Schaltung (1) mit Druck angelegt werden kann und das an einer dem Außengehäuse (6) zugewandten Rückseite der elektrischen Schaltung (1) angeordnet ist, während der Energiespeicher (2) bzw. die Last an deren Vorderseite anzuschließen ist,
das System dazu ausgebildet ist, dass der erste elektrische Anschluss des Energiespeichers (2) bzw. der Last durch den Federkontakt bzw. durch das elastische Element (7) mit Druck am elektronischen Lastschalter (3) anliegt, und
der erste und der zweite elektrische Anschluss des Energiespeichers (2) bzw. der Last an dessen/deren gegenüberliegenden, voneinander abgewandten Seiten angeordnet sind.

2. System nach Anspruch 1, wobei die elektrische Schaltung (1) eine zumindest einmalig biegbare Platine, insbesondere eine semiflexible Flachbaugruppe, umfasst, die mit den genannten elektrischen Kontakten bestückt ist.

3. System nach Anspruch 1 oder 2, wobei der elektronische Lastschalter (3) ein Transistor, insbesondere ein Feldeffekttransistor, oder ein Thyristor, insbesondere ein GTO-Thyristor, ist.

4. System nach einem der voranstehenden Ansprüche, wobei das elektrisch leitende Gehäuse ein flach ausgebildetes metallisches Gehäuse ist, das den elektronischen Lastschalter (3), der insbesondere ein Feldeffekttransistor ist, auf der zum unmittelbaren Kontaktieren des Energiespeichers (2) bzw. der Last vorgesehenen Seite bedeckt.

5. System nach einem der voranstehenden Ansprüche, wobei der Energiespeicher (2) ein wieder aufladbarer Energiespeicher, insbesondere ein Akkumulator ist.

6. Verfahren zum elektrischen Kontaktieren eines Energiespeichers (2) und/oder einer Last an einer elektrischen Schaltung (1), die einen ersten und einen zweiten elektrischen Kontakt zum Anschließen an einen ersten und einen zweiten elektrischen Anschluss eines Energiespeichers (2) und/oder einer Last aufweist,
wobei der erste und der zweite elektrische Anschluss des Energiespeichers (2) bzw. der Last an dessen/deren gegenüberliegenden, voneinander abgewandten Seiten angeordnet sind, und um die elektrische Schaltung (1) ein Außengehäuse (6) angeordnet ist,
wobei mindestens einer der genannten elektrischen Kontakte ein elektronischer Lastschalter (3) ist, der ein leitendes Gehäuse aufweist, das in dem Verfahren durch Anschließen des Energiespeichers (2) bzw. der Last einen unmittelbaren elektrischen und mechanischen Kontakt zu dem ersten elektrischen Anschluss des Energiespeichers (2) bzw. der Last herstellt,
wobei entweder der zweite elektrische Kontakt der elektrischen Schaltung (1), an dem der zweite elektrische Anschluss des Energiespeichers (2) bzw. der Last angeschlossen wird, ein metallischer Federkontakt ist, oder der zweite elektrische Anschluss des Energiespeichers (2) bzw. der Last mittels eines elastischen Elements (7), insbesondere einer Feder, an dem zweiten elektrischen Kontakt der elektrischen Schaltung (1) mit Druck angelegt wird, wobei das elastische Element (7) an einer dem Außengehäuse (6) zugewandten Rückseite der elektrischen Schaltung (1) angeordnet ist, während der Energiespeicher (2) bzw. die Last an deren Vorderseite angeschlossen ist,
so dass in dem Verfahren der erste elektrische Anschluss des Energiespeichers (2) bzw. der Last durch den Federkontakt bzw. durch das elastische Element (7) mit Druck am elektronischen Lastschalter (3) angelegt wird.

7. Verfahren nach Anspruch 6, bei dem
die elektrische Schaltung (1) eine zumindest einmalig biegbare Platine ist, die zumindest lokal zu einer U-Form verbogen wird, wobei an einem von deren Schenkeln (4, 5) innenseitig der elektronische Lastschalter (3) angeordnet ist, und
der Energiespeicher (2) bzw. die Last in die U-Form derart hineingesetzt wird, dass anschließend dessen/deren erster elektrischer Anschluss im unmittelbaren mechanischen und elektrischen Kontakt mit dem elektronischen Lastschalter (3) steht.

8. Verwendung des elektronischen Lastschalters (3) in einem System nach einem der Ansprüche 1 bis 5 zum Ein- und Ausschalten des Energiespeichers (2) bzw. der Last in der elektrischen Schaltung (1), zu einer Notabschaltung, zu einem zeitgesteuerten Betrieb eines Teils der elektrischen Schaltung (1) oder zum Messen der Temperatur des Energiespeichers (2) bzw. der Last mittels der Temperaturabhängigkeit einer Kennlinie des elektronischen Lastschalters (3).

## Claims

1. A system comprising an electrical circuit (1) having a first and a second electrical contact for connection to a first and a second electrical connection terminal of an energy storage device (2) and/or a load, and an outer housing (6) arranged around the electrical circuit (1), wherein
at least one of said electrical contacts is an electronic load switch (3) having a conductive housing which is designed to be directly connected to the energy storage device (2) or load when the energy storage device (2) or load is connected,
either the second electrical contact of the electrical circuit (1), to which the second electrical connection terminal of the energy storage device (2) or load is to be connected, is a metal contact spring, or the system has an elastic element (7), in particular a spring, by means of which the second electrical connection terminal of the energy storage device (2) or load can be applied with pressure to the second electrical contact of the electrical circuit (1) and which is arranged on a rear side of the electrical circuit (1) facing the outer housing (6), while the energy storage device (2) or load is to be connected to the front side thereof,
the system is designed so that the first electrical connection terminal of the energy storage device (2) or load is applied with pressure to the electronic load switch (3) by the contact spring or by the elastic element (7), and
the first and second electrical connection terminals of the energy storage device (2) or load are arranged on opposite sides thereof, facing away from each other.

2. The system according to claim 1, wherein the electrical circuit (1) comprises a printed circuit board which can be bent at least once, in particular a semi-flexible printed circuit board assembly, which is equipped with said electrical contacts.

3. The system according to claim 1 or 2, wherein the electronic load switch (3) is a transistor, in particular a field effect transistor, or a thyristor, in particular a GTO thyristor.

4. The system according to any preceding claim, wherein the electrically conductive housing is a flat metallic housing which covers the electronic load switch (3), which is in particular a field effect transistor, on the side provided for direct contact with the energy storage device (2) or load.

5. The system according to any preceding claim, wherein the energy storage device (2) is a rechargeable energy storage device, in particular an accumulator.

6. A method for electrically contacting an energy storage device (2) and/or a load to an electrical circuit (1) which has a first and a second electrical contact for connection to a first and a second electrical connection terminal of an energy storage device (2) and/or a load,
wherein the first and the second electrical connection terminal of the energy storage device (2) or load are arranged on opposite sides thereof facing away from each other, and an outer housing (6) is arranged around the electrical circuit (1),
wherein at least one of said electrical contacts is an electronic load switch (3), which has a conductive housing, for which the method establishes, by connecting the energy storage device (2) or load, a direct electrical and mechanical contact to the first electrical connection terminal of the energy storage device (2) or load,
wherein either the second electrical contact of the electrical circuit (1), to which the second electrical connection terminal of the energy storage device (2) or load is connected, is a metal contact spring, or the second electrical connection terminal of the energy storage device (2) or load is applied with pressure to the second electrical contact of the electrical circuit (1) by means of an elastic element (7), in particular a spring, the elastic element (7) being arranged on a rear side of the electrical circuit (1) facing the outer housing (6), while the energy storage device (2) or load is connected to the front side thereof,
so that in the method applies the first electrical connection terminal of the energy storage device (2) or load with pressure to the electronic load switch (3) by the contact spring or by the elastic element (7).

7. The method according to claim 6, wherein
the electrical circuit (1) is a plate which can be bent at least once and which is bent at least locally into a U-shape, the electronic load switch (3) being arranged on the inside of one of its limbs (4, 5), and
the energy storage device (2) or load is inserted into the U-shape in such a manner that the first electrical connection terminal thereof is in direct mechanical and electrical contact with the electronic load switch (3).

8. Use of the electronic load switch (3) in a system according to one of claims 1 to 5 for switching the energy storage device (2) or load in the electrical circuit (1) on and off, for an emergency shutdown, for time-controlled operation of a part of the electrical circuit (1) or for measuring the temperature of the energy storage device (2) or load by means of the temperature dependence of a characteristic curve of the electronic load switch (3).

## Revendications

1. Système, comprenant un circuit électrique (1), qui présente un premier et un second contact électrique pour le raccordement à une première et une seconde borne électrique d'un accumulateur d'énergie (2) et/ou d'une charge, ainsi qu'un boîtier extérieur (6) disposé autour du circuit électrique (1), dans lequel
au moins un desdits contacts électriques est un commutateur de charge électronique (3) qui présente un boîtier conducteur configuré de telle sorte qu'il produit un contact électrique et mécanique directement vers la première borne électrique de l'accumulateur d'énergie (2) respectivement de la charge lors du raccordement de l'accumulateur d'énergie (2) respectivement de la charge,
soit le second contact électrique du circuit électrique (1), au niveau duquel la seconde borne électrique de l'accumulateur d'énergie (2) respectivement de la charge est à raccorder, est un contact métallique à ressort, soit le système présente un élément élastique (7), en particulier un ressort, au moyen duquel la seconde borne électrique de l'accumulateur d'énergie (2) respectivement de la charge peut avoir une pression appliquée au niveau du second contact électrique du circuit électrique (1) et lequel est disposé au niveau d'une face arrière du circuit électrique (1) qui est en regard du boîtier extérieur (6), tandis que l'accumulateur d'énergie (2) respectivement la charge est à raccorder au niveau de sa face avant,
le système est formé de telle sorte que la première borne électrique de l'accumulateur d'énergie (2) respectivement de la charge se voit appliquer une pression par le contact de ressort respectivement par l'élément élastique (7) au niveau du commutateur de charge électronique (3), et
la première et la seconde borne électrique de l'accumulateur d'énergie (2) respectivement de la charge sont disposées au niveau de leurs faces opposées l'une à l'autre.

2. Système selon la revendication 1, dans lequel le circuit électrique (1) comprend une platine qui peut se ployer au moins une fois, en particulier un bloc plat semi-flexible, qui est équipé desdits contacts électriques.

3. Système selon la revendication 1 ou 2, dans lequel le commutateur de charge électronique (3) est un transistor, en particulier un transistor à effet de champ, ou un thyristor, en particulier un thyristor GTO.

4. Système selon une des revendications précédentes, dans lequel le boîtier électriquement conducteur est un boîtier métallique de forme plate, qui recouvre le commutateur de charge électronique (3), qui est en particulier un transistor à effet de champ, sur la face prévue pour le contact direct de l'accumulateur d'énergie (2) respectivement de la charge.

5. Système selon une des revendications précédentes, dans lequel l'accumulateur d'énergie (2) est un accumulateur d'énergie rechargeable, en particulier un accumulateur.

6. Procédé pour mettre en contact direct un accumulateur d'énergie (2) et/ou une charge au niveau d'un circuit électrique (1), qui présente un premier et un second contact électrique pour le raccordement à une première et une seconde borne électrique d'un accumulateur d'énergie (2) et/ou d'une charge,
dans lequel la première et la seconde borne électrique de l'accumulateur d'énergie (2) respectivement de la charge sont disposées au niveau de leurs faces opposées l'une à l'autre, et autour du circuit électrique (1) est disposé un boîtier extérieur (6),
dans lequel au moins un desdits contacts électriques est un commutateur de charge électronique (3) qui présente un boîtier conducteur qui, dans le procédé, produit un contact électrique et mécanique directement vers la première borne électrique de l'accumulateur d'énergie (2) respectivement de la charge lors du raccordement de l'accumulateur d'énergie (2) respectivement de la charge,
dans lequel soit le second contact électrique du circuit électrique (1), au niveau duquel la seconde borne électrique de l'accumulateur d'énergie (2) respectivement de la charge est raccordée, est un contact métallique à ressort, soit la seconde borne électrique de l'accumulateur d'énergie (2) respectivement de la charge se voit appliquer, à l'aide d'un élément élastique (7), en particulier un ressort, une pression au niveau du second contact électrique du circuit électrique (1),
dans lequel l'élément élastique (7) est disposé au niveau d'une face arrière du circuit électrique (1) qui se trouve en regard du boîtier extérieur (6) tandis que l'accumulateur d'énergie (2) respectivement la charge est raccordée au niveau de sa face avant,
de telle sorte que dans le procédé la première borne électrique de l'accumulateur d'énergie (2) respectivement de la charge se voit appliquer une pression au niveau du commutateur de charge électronique (3) par le contact de ressort respectivement par l'élément élastique (7).

7. Procédé selon la revendication 6, dans lequel
le circuit électrique (1) est une platine qui peut se ployer au moins une fois, qui est pliée au moins localement en forme de U, dans lequel est disposé sur une de ses branches (4, 5) côté intérieur le commutateur de charge électronique (3), et
l'accumulateur d'énergie (2) respectivement la charge est inséré(e) dans la forme en U de telle sorte qu'ensuite sa première borne électrique se trouve en contact mécanique et électrique direct avec le commutateur de charge électronique (3).

8. Utilisation du commutateur de charge électronique (3) dans un système selon une des revendications 1 à 5 pour activer et désactiver l'accumulateur d'énergie (2) respectivement la charge dans le circuit électrique (1), vers un arrêt d'urgence, vers un fonctionnement régulé dans le temps d'une partie du circuit électrique (1) ou pour la mesure de la température de l'accumulateur d'énergie (2) respectivement de la charge à l'aide d'une variation en fonction de la température d'une caractéristique du commutateur de charge électronique (3).
